# EUROPEAN PATENT APPLICATION

(11) **EP 2 568 499 A2**
(43) Date of publication of application: **13.03.2013**
(21) Application number: 12173767.0
(22) Date of filing: 27.06.2012
(51) Int. Cl.: H01L 25/065

(54) **Semiconductor device including insulating resin film provided in a space between semiconductor chips**

(30) Priority: 01.07.2011 JP 2011147225
(71) Applicant: Elpida Memory, Inc., Tokyo (JP)
(72) Inventor: Koyanagi, Tadashi, Tokyo (JP)
(74) Representative: Glawe, Delfs, Moll

(57) **Abstract**

A semiconductor device includes a first semiconductor, a second semiconductor, and an insulating resin. The first semiconductor chip includes first and second electrodes formed on first and second surfaces thereof, respectively, and a through electrode electrically connecting the first electrode to the second electrode. The second semiconductor chip includes a third electrode formed on a third surface thereof. The insulating resin film includes a flux activator. The insulating resin film is provided a space between the first and the second semiconductor chips.

## Description

### Background of the Invention:

### [Field of the Invention]

This invention relates to a semiconductor device.

### [Description of Related Art]

In recent years, the scale of integration of a semiconductor chip improves year after year, with this, upsizing of a chip size, finer and multi-layering of wiring and so on are proceeding. On the other hand, it is necessary to miniaturize a package size and to reduce the thickness thereof for the sake of high-density packaging.

In regard to such demands, it has been working on development of technique for high-density packaging a plurality of semiconductor chips on a wiring substrate that is called MCP (Multi Chip Package). Among them, it has been focused attention on a CoC (Chip on Chip) type semiconductor package (semiconductor device) for mounting, on a surface of the wiring substrate, a chip stacked structure in which semiconductor chips having through electrodes including through vias each called TSV (Through Silicon Via) are stacked.

The above-mentioned through electrode is disposed so as to penetrate the semiconductor chips. In addition, the through via is disposed so as to penetrate a semiconductor substrate (specifically speaking, a monocrystalline Si substrate) and comprises a conductor serving as a part of the above-mentioned through electrode.

Furthermore, the through electrode has both ends at which the wiring substrate and a bump electrode connected to another semiconductor chip are disposed, respectively.

The semiconductor chip having the above-mentioned through electrodes has structure of mechanically low strength because it is made a thin plate (e.g. 50 micrometers or less) from the viewpoint of forming the through vias penetrating the semiconductor substrate.

Conventionally, during assembly of the semiconductor device, a wafer which is adhesively fixed to a dicing tape is individually divided into a plurality of semiconductor chips. The divided semiconductor chips are pick-up one after another by peeling them from the dicing tape. The picked-up semiconductor chips are mounted, for example, on the wiring substrate.

JP-A-2003-124290 (which will be also called Patent Document 1) discloses a peeling device and a peeling method for a semiconductor chip which comprises pushing-up a back surface of the semiconductor chip by means of a first pushing-up mechanism and a second pushing-up mechanism in a state where a dicing tape is sucked by means of a suction stage to peel the semiconductor chip from the dicing tape.

In addition, JP-A-2009-260229 (which will be also called Patent Document 2) discloses a technique which comprising the steps of forming an insulating resin layer on a circuit surface of a wafer so as to embed projection electrodes, of bonding a resin surface to a dicing tape, of dicing the wafer together with the insulating resin layer from a back surface thereof, and of mounting individualized semiconductor chips on a substrate although the semiconductor chips do not have through electrodes.

Furthermore, JP-A-2009-260230 (which will be also called Patent Document 3) and JP-A-2009-260225 (which will be also called Patent Document 4) disclose techniques similar to that of the above-mentioned Patent Document 2.

However, Patent Documents 1-4 do not take into account that comprising of steps of peeling, from a dicing tape, a semiconductor chip (a mechanically strength low semiconductor ship) which has through electrodes and which is made a thin plate, and of picking-up them.

Accordingly, when the semiconductor chip having the through electrode and subjected to the thin plate is peeled from the dicing tape by using the peeling method for the semiconductor chip described in Patent Document 1, one bump electrode embedded in an adhesive layer of the dicing tape serving as an anchor and the bump electrode gets snagged on adhesive layer. It is therefore in danger of occurring the failure of the semiconductor chip (for instance, chip crack which makes the through electrode the starting point) and picking-up error of the semiconductor chip.

### Summary:

The present invention seeks to solve one or more of the above problems, or to improve upon those problems at least in part.

In one embodiment, there is provided a semiconductor device that includes a first semiconductor chip, a second semiconductor chip, and an insulating resin film. The first semiconductor chip includes a first surface, a second surface opposite to the first surface, a first electrode formed on the first surface, a second electrode formed on the second surface, and a through electrode electrically connecting the first electrode to the second electrode. The second semiconductor chip includes a third surface, a fourth surface opposite to the third surface, and a third electrode formed on the third surface. The fourth surface is free of any electrode. The second semiconductor chip is stacked over the first semiconductor chip so that the third electrode electrically connects to the second electrode. The insulating resin film includes a flux activator. The insulating resin film is provided in a space between the first and second semiconductor chips.

### Brief Description of the Drawings:

The above features and advantages of the present invention will be more apparent from the following description of certain preferred embodiments taken in conjunction with the accompanying drawings, in which:
Fig. 1 is a sectional view showing a first stage of a manufacturing process of a semiconductor device according to an exemplary embodiment of this invention;
Fig. 2 is a sectional view showing a second stage of the manufacturing process of the semiconductor device according to the exemplary embodiment of this invention;
Fig. 3 is a sectional view showing a third stage of the manufacturing process of the semiconductor device according to the exemplary embodiment of this invention;
Fig. 4 is a sectional view showing a fourth stage of the manufacturing process of the semiconductor device according to the exemplary embodiment of this invention;
Fig. 5 is a sectional view showing a fifth stage of the manufacturing process of the semiconductor device according to the exemplary embodiment of this invention;
Fig. 6 is a sectional view showing a sixth stage of the manufacturing process of the semiconductor device according to the exemplary embodiment of this invention;
Fig. 7 is a sectional view showing a seventh stage of the manufacturing process of the semiconductor device according to the exemplary embodiment of this invention;
Fig. 8 is a sectional view showing an eighth stage of the manufacturing process of the semiconductor device according to the exemplary embodiment of this invention;
Fig. 9 is a sectional view showing a ninth stage of the manufacturing process of the semiconductor device according to the exemplary embodiment of this invention;
Fig. 10 is a sectional view showing a tenth stage of the manufacturing process of the semiconductor device according to the exemplary embodiment of this invention;
Fig. 11 is a sectional view showing an eleventh stage of the manufacturing process of the semiconductor device according to the exemplary embodiment of this invention;
Fig. 12 is a sectional view showing a twelfth stage of the manufacturing process of the semiconductor device according to the exemplary embodiment of this invention;
Fig. 13 is a sectional view showing a thirteenth stage of the manufacturing process of the semiconductor device according to the exemplary embodiment of this invention;
Fig. 14 is a sectional view showing a fourteenth stage of the manufacturing process of the semiconductor device according to the exemplary embodiment of this invention;
Fig. 15 is a sectional view showing a fifteenth stage of the manufacturing process of the semiconductor device according to the exemplary embodiment of this invention;
Fig. 16 is a sectional view showing a sixteenth stage of the manufacturing process of the semiconductor device according to the exemplary embodiment of this invention;
Fig. 17 is a sectional view showing a seventeenth stage of the manufacturing process of the semiconductor device according to the exemplary embodiment of this invention;
Fig. 18 is a sectional view showing an eighteenth stage of the manufacturing process of the semiconductor device according to the exemplary embodiment of this invention;
Fig. 19 is a sectional view showing a nineteenth stage of the manufacturing process of the semiconductor device according to the exemplary embodiment of this invention;
Fig. 20 is a sectional view showing a twentieth stage of the manufacturing process of the semiconductor device according to the exemplary embodiment of this invention;
Fig. 21 is a sectional view showing a twenty-first stage of the manufacturing process of the semiconductor device according to the exemplary embodiment of this invention;
Fig. 22 is a sectional view showing a twenty-second stage of the manufacturing process of the semiconductor device according to the exemplary embodiment of this invention;
Fig. 23 is a sectional view showing a twenty-third stage of the manufacturing process of the semiconductor device according to the exemplary embodiment of this invention; and
Fig. 24 is a sectional view showing a twenty-fourth stage of the manufacturing process of the semiconductor device according to the exemplary embodiment of this invention.

### Detailed description of the Preferred Embodiments:

The invention will be now described herein with reference to illustrative embodiments. Those skilled in the art will recognize that many alternative embodiments can be accomplished using the teachings of the present invention and that the invention is not limited to the embodiments illustrated for explanatory purposes.

Referring now to Figures, exemplary embodiments to which this application is applicable will be described in detail. For your information, the drawings for use in description herein are for the sake of describing configuration of the exemplary embodiments according to this invention and there may be cases where sizes, thickness, dimensions, and so on in respective parts illustrated are different from those of an actual semiconductor chip forming motherboard and an actual semiconductor device.

### (Exemplary embodiment)

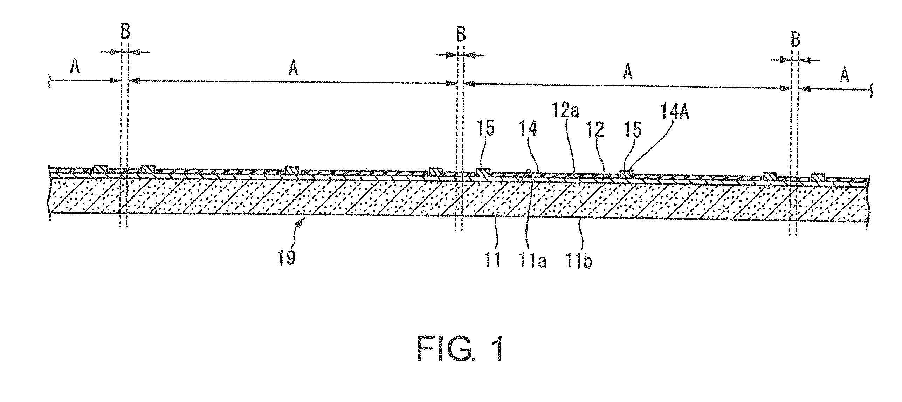

Figs. 1 through 24 are sectional views showing a manufacturing process of a semiconductor device according to an exemplary embodiment of this invention.

Referring to Figs. 1 through 24, the description will proceed to a method of manufacturing of the semiconductor device according to the exemplary embodiment.

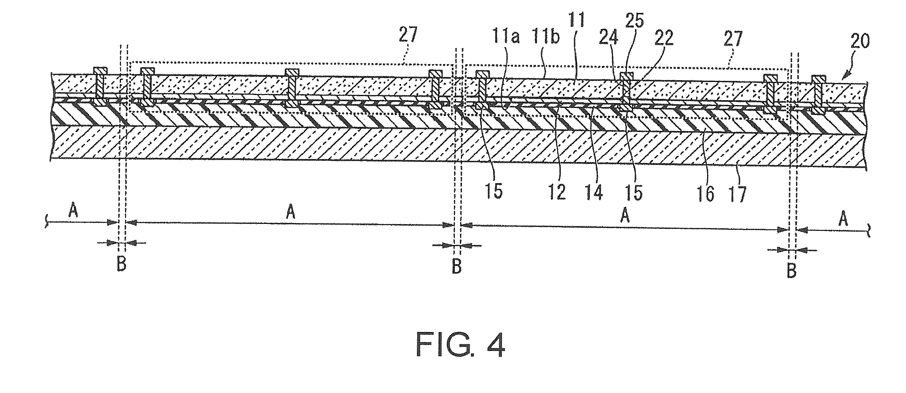

Initially, a process illustrated in Fig. 1 prepares a semiconductor substrate 11 having a plurality of chip forming areas A in each of which a first semiconductor chip (see, Fig. 4) (not shown in Fig. 1) is formed and a plurality of dicing areas B for partitioning the plurality of chip forming areas A. The semiconductor substrate 11 has a first surface 11 a which is a flat surface and a second surface 11 b which is positioned on the opposite side of the first surface 11a and which is a flat surface.

As the semiconductor substrate 11, for example, a monolithic silicon wafer may be used.

Subsequently, the process illustrated in Fig. 1 forms a first circuit element layer 12 in the plurality of chip forming areas A within the first surface 11a of the semiconductor substrate 11. The first circuit element layer 11 comprises a multilayer wiring structure which comprises transistor elements, a plurality of laminated interlayer insulating layers, wiring patterns (wiring, vias, and so on) formed in the plurality of interlayer insulating layers, and so on.

As the first semiconductor chip 27 illustrated in Fig. 4, a memory semiconductor chip may be used. As the memory semiconductor chip, a DRAM (Dynamic Random Access Memory) chip may be used. When the DRAM chip is used as the first semiconductor chip 27, DRAM elements (not shown) are formed in the first circuit element layer 12.

In this connection, in this exemplary embodiment, the description will herein proceed citing an example in a case where the memory semiconductor chip is used as the first semiconductor chip 27.

Subsequently, the process illustrated in Fig. 1 forms, on a surface 12a of the first circuit element layer 12, a protection film (a passivation film)14 having opening portions 14A each of which exposes forming areas for first bump electrodes 15.

The protection film 14 is a film for protecting the first circuit element layer 12 and is formed by using an insulating resin (e.g. a polyimide resin).

Subsequently, the process illustrated in Fig. 1 forms, on the surface 12a of the first circuit element layer 12 that is exposed by the opening portions 14A, the first bump electrodes 15 electrically connected to memory circuit elements. At this time, the first bump electrodes 15 are formed so as to have a height projecting from a surface of the protection film 14. Specifically, the height of each first bump electrode 15 may be equal, for example, to 20 micrometers.

The first bump electrodes 15 are electrodes serving as surface electrodes and have a surface on which solder layers (not shown) are formed. The first bump electrodes 15 are connected to transistor elements (not shown) provided in the first circuit element layer 12. As a material of each first bump electrode 15, for example, Cu may be used.

Thereby, a structure 19 is formed which serves as a part of constituent elements of a semiconductor chip forming motherboard 20 shown in Fig. 4 that will later be described.

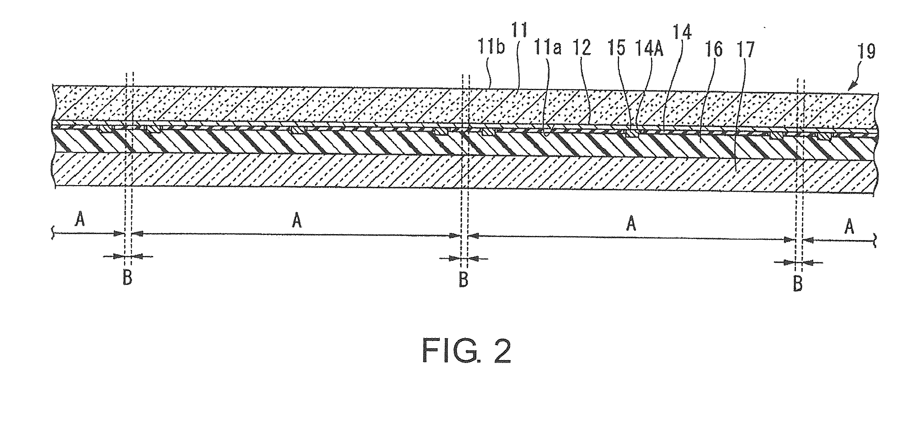

Subsequently, a process illustrated in Fig. 2 turns the structure 19 shown in Fig. 1 upside down and thereafter bonds a supporting substrate 17 via an adhesive member 16 to a surface of the structure 19 that is a side in which the protection film 14 is formed. As a material of the adhesive member 16, an object where sparkling or tack power is reduced by reaction with a particular light source (e.g. laser light or UV light (ultraviolet light)) may be preferably used.

As the supporting substrate 17, for example, a light-transparent substrate (e.g. a glass substrate) may be used.

The adhesive member 16 is formed so that thickness thereof becomes thickness enable to perfectly embed the first bump electrodes 15. Specifically, when the height of each first bump electrode 15 is 20 micrometers, the thickness of the adhesive member 16 may be, for example, 50 micrometers.

It is therefore possible to support the structure 19 by means of the supporting substrate 16 without damage to the first bump electrodes 15 because the thickness of the adhesive member 16 is the thickness enable to perfectly embed the first bump electrodes 15.

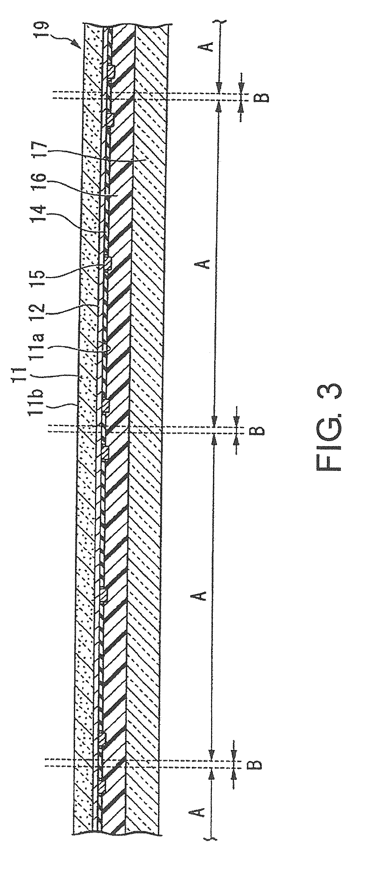

Subsequently, a process illustrated in Fig. 3 makes the semiconductor substrate 11 a thin plate by grinding or polishing the semiconductor substrate 11 from a side of the second surface 11b of the semiconductor substrate 11 shown in Fig. 2. In this event, the semiconductor substrate 11 is made the thin plate so that the thickness of the structure 19 becomes, for example, 50 micrometers or less.

Inasmuch as the structure 19 subjected to the thin plate is supported by the supporting substrate 17, it is possible to easily carry out handling of the structure 19 after making the thin plate (e.g. transfer between semiconductor manufacturing apparatuses or the like).

Subsequently, a process illustrated in Fig. 4 forms through holes 22 each of which penetrates a part opposite to the first bump electrode 15 in the first circuit element layer 12 and the semiconductor substrate 11. The through holes 22 are formed so as to expose electrode pads (not shown) in which the first bump electrodes 15 are formed.

Subsequently, the process illustrated in Fig. 4 forms an insulating layer (not shown) which covers side surfaces of the through holes 22 and the second surface 11 b of the semiconductor substrate 11. Subsequently, the process illustrated in Fig. 4 forms a plating mask (not shown) having opening portions exposing the through holes 22 on the insulating layer formed on the second surface 11 b of the semiconductor substrate 11.

Subsequently, the process illustrated in Fig. 4 forms a seed layer (e.g. a Cu layer) (not shown) which covers inner surfaces of the through holes 22, a surface of the plating mask (including side surfaces of the opening portions), and an upper surface of the insulating layer that is exposed in the opening portions, and forms a plating resist film (e.g. Cu plating resist film) (not shown) which embeds the through holes 22 and the opening portions by means of an electrolytic plating method making the seed layer a feeding layer.

Subsequently, the process illustrated in Fig. 4 removes the plating resist film, and thereafter removes the seed layer which is not covered by the plating firm to form through electrodes 24 and second bump electrodes 25 by one operation. Each through electrode 24 is disposed in the through hole 22 and has one end connected to the first bump electrode 15. Each second bump electrode 25 is integrally composed of another end of the through electrode 24 and projects from the insulating layer (not shown). The through electrodes 24 and the second bump electrodes 25 are electrically insulated to the semiconductor substrate 11 by the insulating layer.

Thereby, the semiconductor chip forming motherboard 20 is formed. The semiconductor chip forming motherboard 20 comprises the semiconductor substrate 11 subjected to the thin plate, the first circuit element layer 12, the protection film 14, the fist bump electrodes 15, the insulating layer (not shown), the through electrodes 24, and the second bump electrodes 25 and comprises a motherboard in which the first semiconductor chips 27 are formed in the plurality of chip forming areas A. Therefore, the semiconductor chip forming motherboard 20 is prepared. Besides, in this stage, the plurality of first semiconductor chips 27 are coupled to one another and are not individualized.

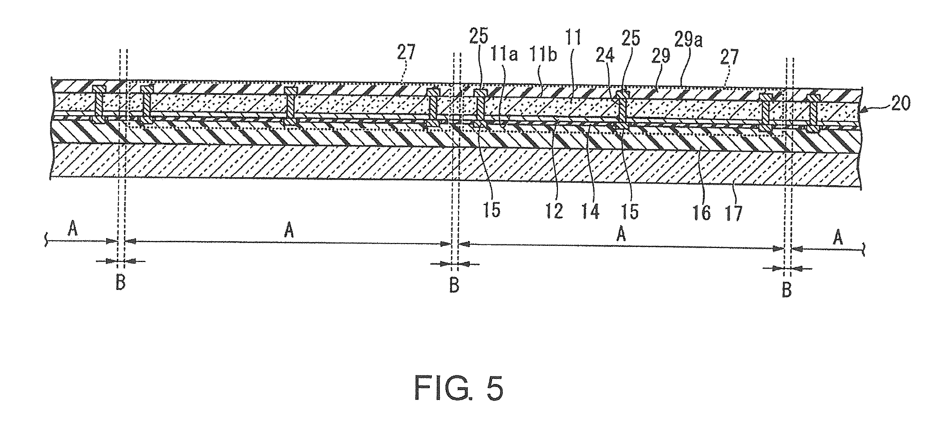

Subsequently, a process illustrated in Fig. 5 forms an insulating resin layer 29 (an insulating resin layer with adhesiveness) covering the second bump electrodes 25 on a surface of the semiconductor chip forming motherboard 20 that is positioned at a side to which the second bump electrodes 25 are provided. The insulating resin layer 29 is also called an insulating resin film.

Specifically, NCF (Non Conductive Film) as the insulating resin layer 29 is pasted on the surface of the semiconductor chip forming motherboard 20 that is positioned at the side to which the second bump electrodes 25 are provided.

It is possible to reduce the amount of curling in the semiconductor chip forming motherboard 20 caused by the protection film 14 by forming the insulating resin layer 29 on the surface of the semiconductor chip forming motherboard 20 that is positioned at the side in which the second bump electrodes 25 are provided, in the manner which is described above.

In this connection, although the NCF and a conventional underfill compound are made of an epoxy-based resin, the conventional underfill compound is for filling in a space after connecting of a flip chip and contains a solvent for making liquid. Compared with this, the NCF is made of a resin in the form of a film and contains a flux activator in order to favorably connect between bump electrodes on connecting of the flip chip. The flux activator may be, for example, organic acid or amine. Thus, the insulating resin film 29 includes the flux activator.

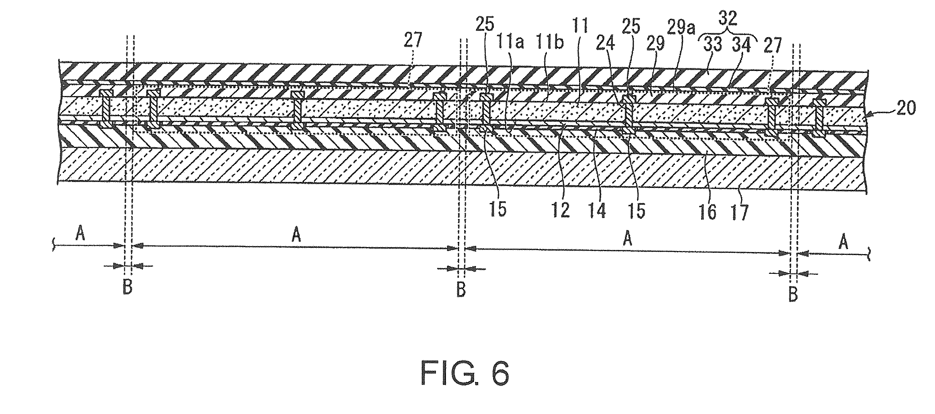

Subsequently, a process illustrated in Fig. 6 prepares a dicing tape 32 comprising a dicing tape body 33 and an adhesive layer 34, and pastes the dicing tape body 33 on a surface 29a of the insulating resin layer 29 via the adhesive layer 34 of the dicing tape 32.

Inasmuch as the dicing tape 32 strung around a ring-shaped jig is pasted on the surface 29a of the insulating resin layer 29 after forming the insulating resin layer 29 so as to cover the second bump electrodes 25 in the manner which is described above, the second bump electrodes 25 are not embedded in the adhesive layer 34.

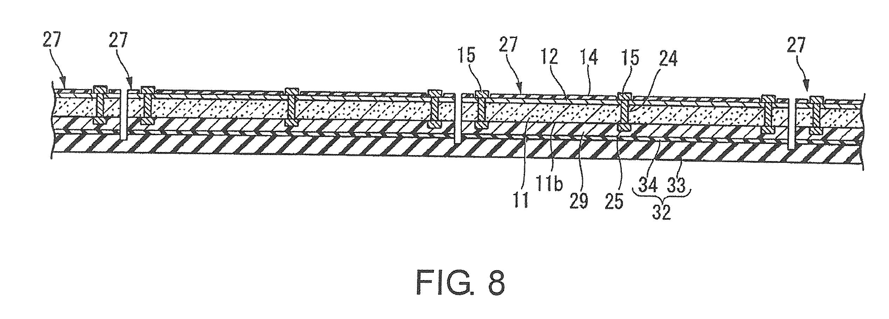

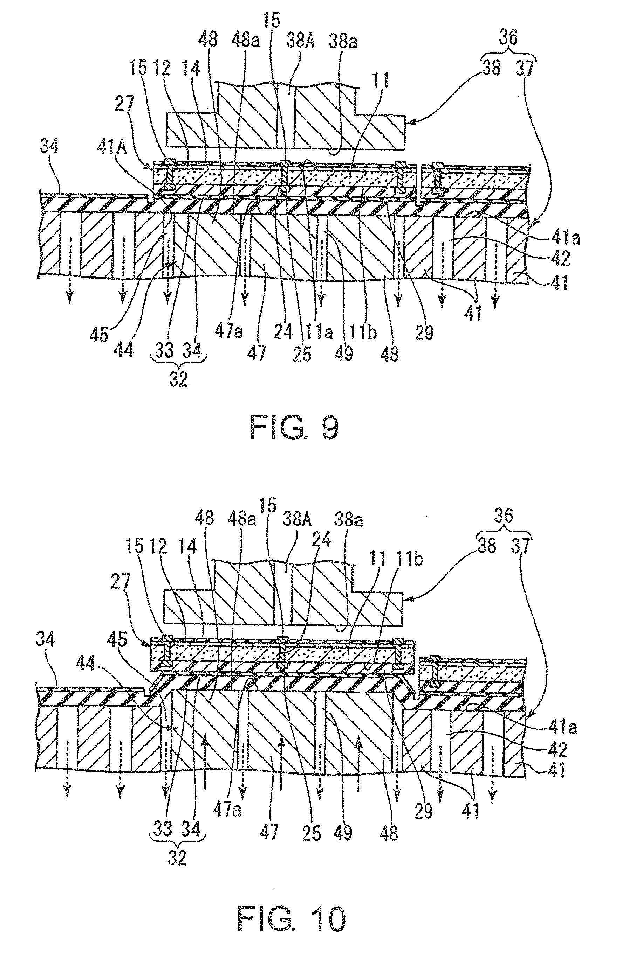

Thereby, inasmuch as the second bump electrodes 25 are not gotten snagged on the adhesive layer 34 on picking-up the first semiconductor chips 25 from the dicing tape 32 (see, processes illustrated in Figs. 10-12 which will later be described) after individualizing the plurality of first semiconductor chips 27 constituting the semiconductor chip forming motherboard 20 (see, a process illustrated in Fig. 8 which will later be described), unnecessary stress is not added to the first semiconductor chips 27 subjected to the thin plate.

It is therefore possible to inhibit the first semiconductor chips 27 subjected to the thin plate from breaking (e.g., chip cracking which makes the through holes 24 the starting points) and from missing of picking-up on picking-up the first semiconductor chips 27 from the dicing tape 32.

In addition, inasmuch as the first semiconductor chips 27 individualized are picked-up together with the insulating resin layer 29 on picking-up the first semiconductor chips 27 from the dicing tape 32, it is possible to inhibit a warp from occurring in the first semiconductor chips 27 picked-up (the semiconductor chips subjected to the this plate) because the insulating resin layer 29 serves as the supporting plate for the first semiconductor chips 27. It is therefore possible to inhibit the first semiconductor chips 27 from breaking.

As the adhesive layer 34 constituting the dicing tape 32, for example, a subject having a property where an adhesive force is reduced by undergoing a chemical reaction in components of an adhesive compound due to the application of ultraviolet rays (UV) may be used.

In this connection, the dicing tape 32 may be pasted via the insulating resin layer 29 on a surface of the semiconductor chip forming motherboard 20 that is positioned at a side to which the second bump electrodes 25 are provided after pasting the insulating resin layer 29 on the adhesive layer 34 of the dicing take 32.

By pasting the dicing tape 32 in the manner which will later be described, it is possible to reduce the stress added to the semiconductor chip forming motherboard 20 in comparison with a case where the insulating resin layer 29 is formed, by means of a spinner method, on the surface of the semiconductor chip forming motherboard 20 that is positioned to the side to which the second bump electrodes 25 are provided.

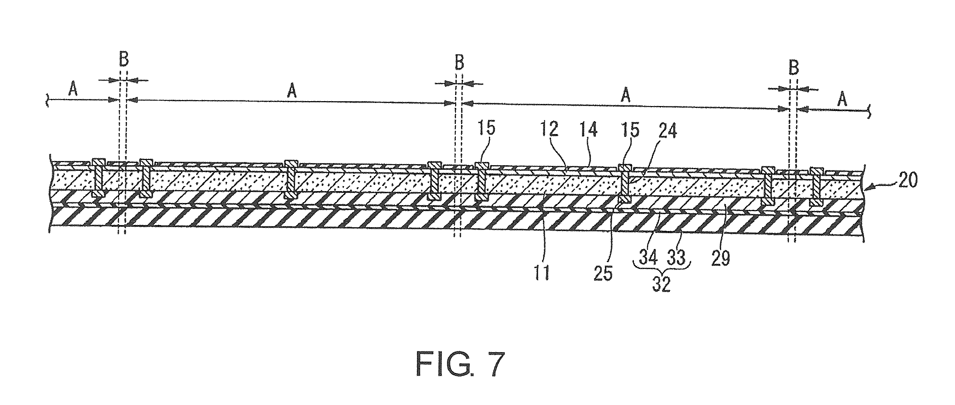

Subsequently, a process illustrated in Fig. 7 turns the structure shown in Fig. 6 upside down, thereafter irradiates the adhesive member 16 with light emitted from a particular light source (e.g. laser light or UV light (ultraviolet light) through the supporting substrate 17 to make the adhesive member 16 foam or reduce the adhesive force thereof, and removes the adhesive member 16 and the supporting substrate 17.

Thereby, the protection film 14 and the first bump electrodes 25 which constitute the semiconductor chip forming motherboard 20 are exposed.

Subsequently, the process illustrated in Fig. 8 holds the structure shown in Fig. 7 on a stage for a dicing device (not shown), and then cuts, by means of a dicing blade (not shown), the semiconductor chip forming motherboard 20 and the insulating resin layer 29 pasted to the dicing tape 32 along the dicing areas B recognized by the dicing device from a side in which the first bump electrodes 15 are formed to individualize the plurality of first semiconductor chips 27. In this event, parts of the dicing tape 32 that correspond to the dicing areas B are cut.

Thereby, as shown in Fig. 8, the insulating resin layer 29 corresponding to the outer shape of the first semiconductor chips 27 is formed at the side of the second surface 11b of the semiconductor substrate 11 (the individualized semiconductor substrate 11) constituting the first semiconductor chips 27.

In the manner which is described above, by cutting the semiconductor chip forming motherboard 20 and the insulating resin layer 29 pasted on the dicing tape 32 in a state of forming the insulating resin layer 29 reducing the warp of the semiconductor chip forming motherboard 20 caused by the protection film 14 consisting of an insulating resin, it is possible to individualize the plurality of first semiconductor chips 27 with high accuracy.

In addition, inasmuch as the semiconductor chip forming motherboard 20 is cut from the side in which the first circuit element layer 14 is formed, it is possible to recognize the dicing areas B with high accuracy without using specific recognition means such as an infrared camera or the like.

Subsequently, the UV light is applied, by means of an ultraviolet light (UV) irradiation mechanism (not shown), to the adhesive layer 34 via the dicing tape body 33 from a side of an undersurface of the structure shown in Fig. 8 to reduce the adhesive force of the adhesive layer 34.

It is therefore possible to easily peel off the insulating resin layer 29 from the adhesive layer 34 of the dicing tape 32.

Subsequently, the process illustrated in Fig. 9 prepares a picking-up device 36. Referring now to Fig. 9, the description will proceed to a schematic structure of the picking-up device 36.

The picking-up device 36 comprises a sucking state 37 and a sucking collet 38. The sucking stage 37 comprises a stage body 41, a first sucking portion 42, a chip pushing-up mechanism 44, and a second sucking portion 45.

The stage body 41 comprises a flat sucking surface 41 a on which the dicing tape 32 (concretely, the dicing tape body 33) provided to the structure shown in Fig. 8 is mounted, and a receiving portion 41A for receiving the chip pushing-up mechanism 44.

The first sucking portion 42 has a plurality of through holes formed in the stage body 41 that are exposed from the sucking surface 41 a. The first sucking portion 42 is connected to a vacuum pump (not shown) and sucks the structure shown in Fig. 8 that is mounted on the sucking surface 41 a of the stage body 41.

The chip pushing-up mechanism 44 comprises a first pushing-up member 47, a second pushing-up member 48, and a third sucking portion 49.

The first pushing-up member 47 is disposed at a center of the receiving portion 41A. The first pushing-up member 47 has a first pushing-up surface 47a which is a rectangular shape and a flat surface. The first pushing-up surface 47a has a shape which is enable to push up a central portion of the first semiconductor chip 27.

The first pushing-up member 47 has a configuration which is enable to move up and down by means of driving means (not shown). By moving the first pushing-up member 47 upward from a state shown in Fig. 9 (a state where the first pushing-up surface 47a is substantially flush with the sucking surface 41 a of the stage body 41), the first pushing-up surface 47a pushes up the central portion of the first semiconductor chip 27 via the dicing tape 32 and the insulating resin layer 29.

The second pushing-up member 48 has a flame shape and is disposed in the receiving portion 41A at a position outside than a position in which the first pushing-up member 47 is disposed. The second pushing-up member 48 has a second pushing-up surface 48a which is the flame shape and a flat surface. The second pushing-up member 48a has a shape which is enable to push up an outer regions of the first semiconductor chip 27.

The second pushing-up member 48 has a configuration which is enable to move up and down by means of driving means (not shown). By moving the second pushing-up member 48 upward from the state shown in Fig. 9 (a state where the second pushing-up surface 48a is substantially flush with the sucking surface 41 a of the stage body 41), the second pushing-up surface 48a pushes up the outer regions of the first semiconductor chip 27 via the dicing tape 32 and the insulating resin layer 29.

In addition, the outside shape of the second pushing-up member 48 is configured so as to become slightly smaller than a size of the outside shape of the first semiconductor chip 27 picked up.

It is therefore possible to peeling up, from the dicing tape 32, a portion of the insulating resin layer 29 provided to the first semiconductor chip 27 that is positioned at the outside than the second pushing-up member 48.

The third sucking portion 49 is a groove-shaped sucking portion which is formed between the first pushing-up member 47 and the second pushing-up member 48 and is connected to a vacuum pump (not shown). Thereby, the third sucking portion 49 sucks the dicing tape 32 which is disposed at the position opposite to the central portion of the first semiconductor chip 27.

The second sucking portion 45 is a groove-shaped sucking portion which is formed between the first pushing-up member 47 and the second pushing-up member 48 and is connected to a vacuum pump (not shown). Thereby, the second sucking portion 45 sucks the dicing tape 32 which is disposed at the position opposite to the outer regions of the first semiconductor chip 27.

The sucking collet 38 is disposed over the sucking stage 37. The sucking collet 38 is connected to driving means (not shown) and has a configuration which is enable to move up and down and in a direction of a plane orthogonal to up and down.

The sucking collet 38 comprises a flat sucking surface 38a opposite to the surface of the first semiconductor chip 27 at a side in which the protection film 14 is formed, and a sucking portion 38A exposed from the sucking surface 38a.

The sucking portion 38A is connected to a vacuum pump (not shown). Thereby, the sucking portion 38A sucks the surface of the first semiconductor chip 27 at the side in which the protection film 14 is formed.

Subsequently, the process illustrated in Fig. 9 mounts the structure shown in Fig. 8 on an upper surface of the sucking stage 37 of the picking-up device 36 (concretely, the sucking surface 41a, the first pushing-up surface 47a, and the second pushing-up surface 48a which are disposed in the same plane) so that the side in which the first bump electrodes 15 are formed becomes a side of the upper surface (put another way, so that the dicing tape 32 provided to the structure shown in Fig. 8 comes into contact with the upper surface of the sucking stage 37).

In this event, the structure shown in Fig. 8 is mounted so that the first semiconductor chip 27 to be picked up is disposed over the chip pushing-up mechanism 44.

Subsequently, the process illustrated in Fig. 9 holds the structure shown in Fig. 8 on the upper surface of the sucking stage 37 by sucking the dicing tape 32 provided to the structure shown in Fig. 8 by means of the first through the third sucking portions 42, 45, and 49.

Subsequently, the process illustrated in Fig. 9 moves the sucking collet 38 over the first semiconductor chip 27 upward so as to be opposite to the first semiconductor ship 27 disposed over the chip pushing-up mechanism 44.

Subsequently, the process illustrated in Fig. 10 moves the first and the second pushing-up surfaces 47a and 48a upward by pushing-up the first and the second pushing-up members 47 and 48 by the same pushing-up amount from a state of the sucking stage 37 shown in Fig. 9.

Thereby, a portion of the first semiconductor chip 27 that is opposite to the chip pushing-up mechanism 44 is pushed up via the dicing tape 32 and the insulating resin layer 29 and a portion of the insulating resin layer 29 provided to the first semiconductor chip 27 that is positioned to the outside than the second pushing-up member 48 is peeled from the dicing tape 32.

Under the circumstances, inasmuch as the first semiconductor ship 27 subjected to the thin plate is pushed up together with the insulating resin layer 29 covering one surface of the first semiconductor chip 27 (the back surface of the first semiconductor chip 27 in which the second bump electrodes 25 are formed), it is possible to inhibit the first semiconductor chip 27 from being damaged due to pushing-up of the first and the second pushing-up members 47 and 48.

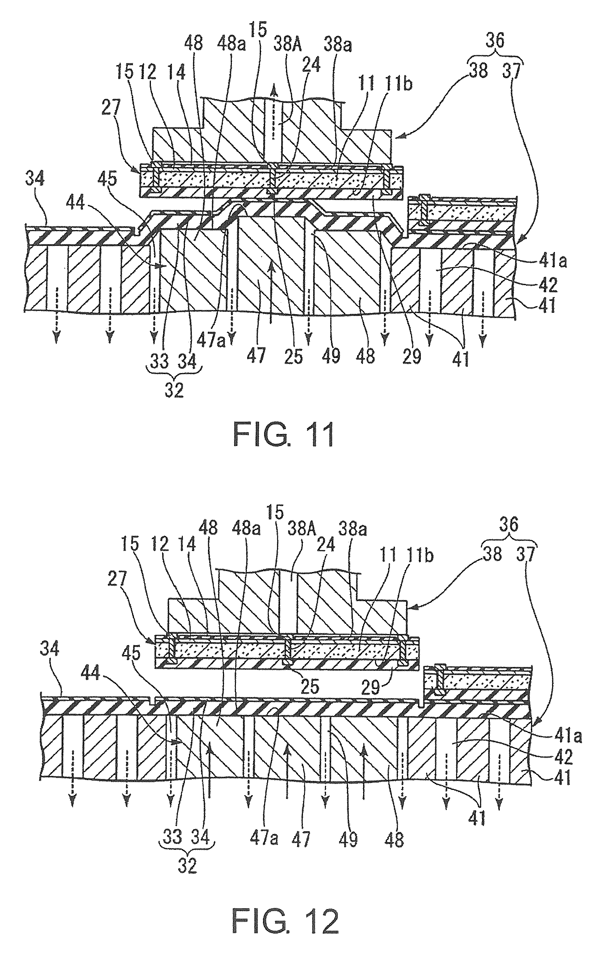

Subsequently, the process illustrated in Fig. 11 moves the first pushing-up surface 47a upward by further pushing-up the first pushing-up member 47 from the state of the sucking stage 37 shown in Fig. 10.

Thereby, a portion of the first semiconductor chip 27 that is opposed to the first pushing-up surface 47a is pushed up via the dicing tape 32 and the insulating resin layer 29 and a portion of the insulating resin layer 29 provided to the first semiconductor chip 27 that is positioned to the outside than the first pushing-up member 48 is peeled from the dicing tape 32.

In this event, the dicing tape 32 is peeled in a direction to trend to the central portion of the first semiconductor chip 27 from an initial peeling location shown in Fig. 10 and a contact area between the insulating resin layer 29 and the dicing tape 32 becomes small. In this stage, by means of the sucking collet 38, the surface of the first semiconductor chip 27 at the side in which the protection film 14 is formed is sucked.

Subsequently, the process illustrated in Fig. 12 moves the first and the second pushing-up surfaces 47a and 48a downward so that the first and the second pushing-up surfaces 47a and 48a are substantially flush with the sucking surface 41a of the stage body 41 from the state of the sucking stage 37 shown in Fig. 11.

Thereby, the dicing tape 32 is peeled from the insulating resin layer 29 formed to the central portion of the first semiconductor chip 27 and the first semiconductor chip 27 (in other words, the first semiconductor chip 27 in which the insulating resin layer 29 is formed) is picked up together with the insulating resin layer 29.

In the manner which is described above, inasmuch as the first semiconductor chip 27 in which the insulating resin layer 29 embedding the second bump electrodes 25 is formed is picked up together with the insulating resin member 29, the second bump electrodes 25 are not embedded in the adhesive layer 34 of the dicing tape 32.

It is therefore possible to inhibit the first semiconductor chip 27 from being damaged (e.g. chip clacking making the through electrodes 24 the starting points) and to inhibit the first semiconductor chip 27 from missing picking-up on picking-up the first semiconductor chip 27 individualized from the dicing tape 32.

In addition, inasmuch as the insulating resin layer 29 serves as the supporting plate for the first semiconductor chip 27 on picking-up the first semiconductor chip 27, it is possible to reduce the warp of the first semiconductor chip 27 picked-up and it is therefore possible to inhibit the first semiconductor chip 27 from being damaged.

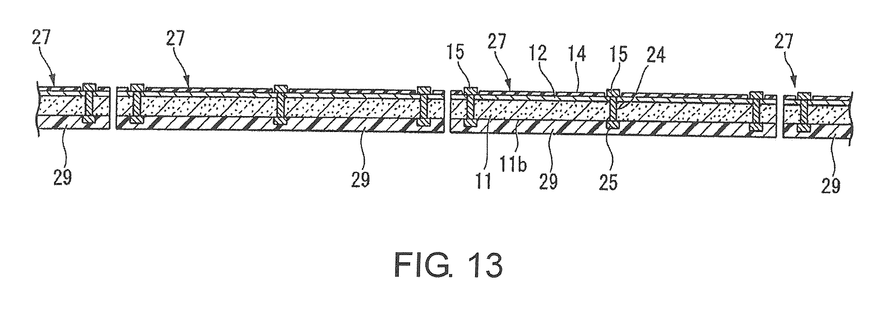

Subsequently, a process illustrated in Fig. 13 forms the plurality of first semiconductor chips 27 in each of which the insulating resin layer 29 is formed by carrying out the processes illustrated in Figs. 9 through 12 in order.

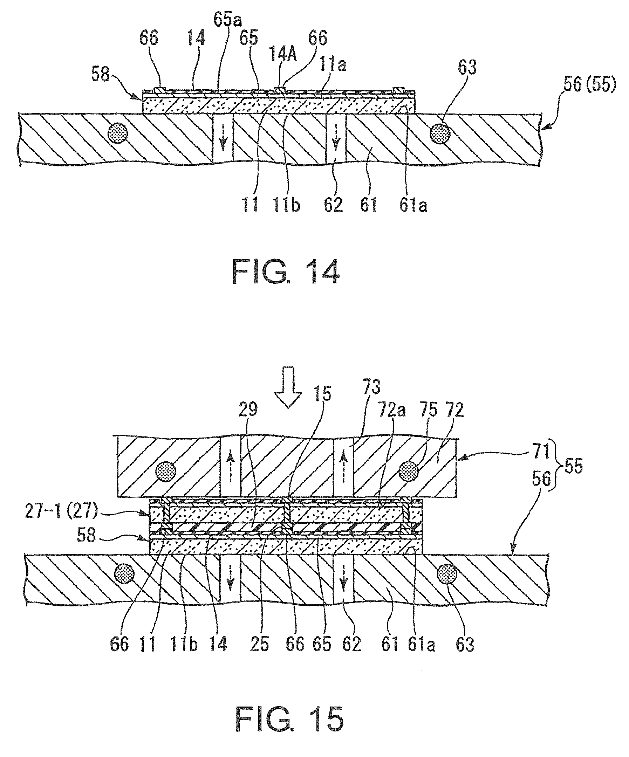

Subsequently, a process illustrated in Fig. 14 sucks a second semiconductor chip 58 preliminarily prepared to a substrate mounting surface 61 a of a stage 56 provided to a bonding device 55. In this event, the second semiconductor chip 58 is sucked so that the second surface 11 b of the semiconductor substrate 11 comes into contact with the substrate mounting surface 61 a.

Referring now to Fig. 14, the description will proceed to configuration of the stage 56 of the bonding device 55. The stage 56 comprises a stage body 61, first sucking holes 62, and a first heating mechanism 63.

The stage body 61 has the flat substrate mounting surface 61 a on which the second semiconductor chip 58 is mounted. The first sucking holes 62 are provided to the stage 61 and are exposed from the substrate mounting surface 61 a. The first sucking holes 62 are connected to a vacuum pump (not shown) and suck the second semiconductor chip 58 mounted on the substrate mounting surface 61 a.

The first heating mechanism 63 is provided within the stage body 61. The first heating mechanism 63 heats the second semiconductor chip 58 sucked to the stage body 61 to predetermined temperature. The fist heating mechanism 63 may be, for example, a cartridge heater.

Referring now Fig. 14, the description will proceed to structure of the second semiconductor chip 58.

The second semiconductor chip 58 is similar in structure to the first semiconductor chip 27 except that a second circuit element layer 56 is provided in lieu of the first circuit element layer 12 provided to the first semiconductor chip 27 shown in Fig. 13, third bump electrodes 66 are provided in place of the first bump electrodes 27 provided to the first semiconductor chip 27, and the through electrodes 24 and the second bump electrodes 25 provided to the first semiconductor chip 27 are removed from constituent elements.

The second circuit element layer 65 is formed on the first surface 11 a of the semiconductor substrate 11. In the second semiconductor chip 58, the first surface 11a is also called a third surface. The second circuit element layer 65 has a multilayer structure comprising transistor elements, a plurality of laminated interlayer insulating layers, and a wiring pattern (wiring, vias, and so on) formed in the plurality of interlayer insulating layers.

The third bump electrodes 66 are formed a surface 65a of the second circuit element layer 65 which are exposed from the opening portions 14A of the protection film 14. That is, the third bump electrodes 66 are formed the third surface 11a of the second semiconductor chip 58. The third bump electrodes 66 are electrically connected to the transistor elements (not shown) provided in the second circuit element layer 65.

Inasmuch as the second semiconductor chip 58 having the above-mentioned structure does not comprise the bump electrodes at the second surface 11 b of the semiconductor substrate 11 (the surface coming into contact with the substrate mounting surface 61a) and as the surface of the semiconductor chip 58 that comes into contact with the substrate mounting surface 61 a is the flat surface, it is possible to securely make the second semiconductor chip 58 suck on the substrate mounting surface 61a of the stage 56. In the second semiconductor chip 58, the second surface 11b is also called a fourth surface. The fourth surface 11b of the second semiconductor chip 58 is free of any electrode.

As the second semiconductor chip 58, a memory semiconductor chip may be used. As the memory semiconductor chip, for example, a DRAM (Dynamic Random Access Memory) chip may be used. In a case where the DRAM chip is used as the second semiconductor chip 58, DRAM elements (not shown) are formed in the second circuit layer 65.

In this connection, in this exemplary embodiment, the description will be later made citing an example of a case where the memory semiconductor chip is used as the second semiconductor chip 58.

Subsequently, before describing a process illustrated in Fig.15, referring to Fig. 15, the description will proceed to configuration of a bonding tool 71 of the bonding device 55 (that is one of constituent elements of the bonding device 55) illustrated in Fig. 15.

The bonding tool 71 comprises a tool body 72, second sucking holes 73, a second heating mechanism 75. The tool body 72 has a pushing surface 72a for pushing the sucked semiconductor chip.

The second sucking holes 73 are provided to the tool body 72 and are exposed from the pushing surface 72a. The second sucking holes 73 are connected to a vacuum pump which is not illustrated. Thereby, the second sucking holes 73 suck the semiconductor chip opposite to the pushing surface 72a.

The second heating mechanism 75 heats the semiconductor chip sucked to the bonding tool 71 to predetermined temperature (e.g. 80-100°C). The second heating mechanism 75 may be, for example, a cartridge heater.

As explained hereafter, "the first semiconductor chip 27" illustrated in Fig. 13 will be referred to as "a first semiconductor chip 27-1" for convenience of the description.

Subsequently, the process illustrated in Fig. 15 sucks the first semiconductor chip 27-1 by means of the bonding tool 71 so that the pushing surface 72a comes into contact with the first bump electrodes 15 provided to the first semiconductor chip 27-1 shown in Fig. 13 and heats the first semiconductor chip 27-1 by means of the second heating mechanism 75 so that .the first semiconductor chip 27-1 has predetermined temperature (e.g. the order of 200°C).

Subsequently, the process illustrated in Fig. 15 moves the bonding tool 71 sucking the first semiconductor chip 27-1 over the second semiconductor chip 58 so that the third bump electrodes 66 of the second semiconductor chip 58 sucked to the state 56 are opposed to the second bump electrodes 25 of the first semiconductor chip 17-1.

Subsequently, the process illustrated in Fig. 15 moves the bonding tool 71 downward (the side of the stage 56) so as to make the insulating resin layer 29 provided to the first semiconductor chip 27-1 come into contact with the third bump electrodes 66 of the second semiconductor chip 58.

Thereafter, the process illustrated in Fig. 15 thermocompression bonds the second bump electrodes 25 and the third bump electrodes 66 (in this stage, temporary bonds) to each other by pushing the first semiconductor chip 27-1 by means of the pushing surface 72a so that the first semiconductor chip 27-1 is connected to the second semiconductor chip 58 in a flip chip fashion, and a space between the first semiconductor chip 27-1 and the second semiconductor ship 58 is sealed by the insulating resin layer 29 because the insulating resin layer 29 molten by heating spreads to the space between the first semiconductor chip 27-1 and the second semiconductor chip 58.

Specifically, a semiconductor device according to a first exemplary embodiment comprises:
the first semiconductor chip (27-1) including the first surface (11a), the second surface (11b) opposite to the first surface, the first electrode (15) formed on the first surface, and the second electrode (25) formed on the second surface;
the second semiconductor chip (58) including the third surface (11a), the fourth surface (11 b) opposite to the third surface, and a third electrode (66) formed on the third surface, the fourth surface being free of any electrode, the second semiconductor chip (58) being stacked over the first semiconductor chip (27-1) so that the third electrode (66) electrically connects to the second electrode (25); and
the insulating resin film (29) including the flux activator, the insulating resin film (29) being provided in a space between the first and second semiconductor chips.

Inasmuch as the second bump electrodes 25 and the third bump electrodes 66 are thermocompression bonded to each other by pushing the first semiconductor chip 27-1 provided with the insulating resin layer 29 to the second semiconductor chip 58 via the insulating resin layer 29 in the manner which is described, it is possible to inhibit the first semiconductor ship 27-1 from be damaged on pushing and it is possible to connect the second bump electrodes 25 to the third bump electrodes 66 with a high degree of positional accuracy because the insulating resin layer 29 serves as the supporting plate for inhibit the warp of the first semiconductor chip 27-1 subjected to the thin plate.

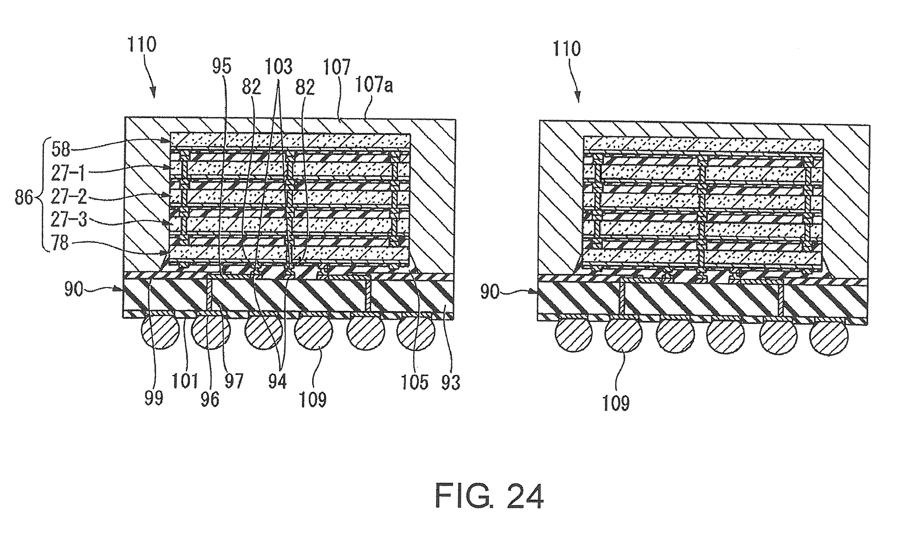

In addition, inasmuch as the second bump electrodes 25 and the third bump electrodes 66 are thermocompression bonded to each other by pushing the first semiconductor chip 27-1 provided with the insulating resin layer 29 to the second semiconductor chip 58 via the insulating resin layer 29, it is possible to simplify manufacturing process of a semiconductor device 110 (see, Fig. 24). This is because the molten insulating resin layer 29 serves as an unferfill resin for sealing the space between the first semiconductor chip 27-1 and the second semiconductor chip 58 and it is therefore unnecessary to separately provide a process for forming the underfill resin for sealing the space between the first semiconductor chip 27-1 and the second semiconductor chip 58. In addition, inasmuch as the insulating resin layer 29 contains the flux activator, it is possible to satisfactory connect the second bump electrodes 25 with the third bump electrodes 66 although flip chip packaging is made after providing the first semiconductor chip 27-1 with the insulating resin layer 29.

As explained hereafter, "the first semiconductor chip 27" with the insulating resin layer 29 illustrated in Fig. 13 will be referred to as "a first semiconductor chip 27-2" for convenience of the description.

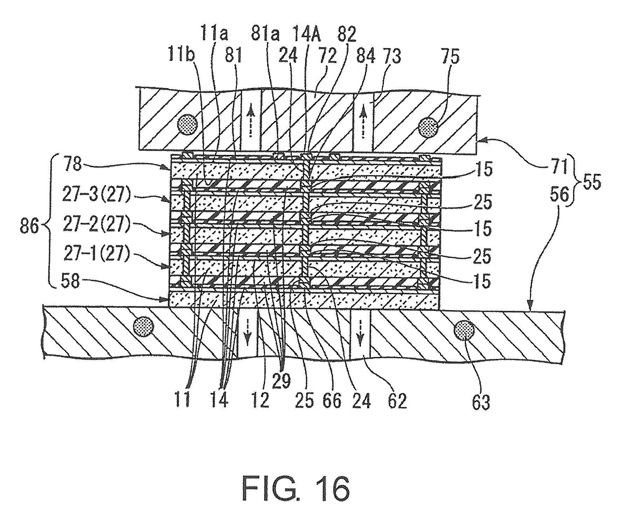

Subsequently, a process illustrated in Fig. 16 sucks the first semiconductor chip 27-2 by of the bonding tool 71 and thereafter carries out processing similar to the process illustrated in Fig. 15 so that the first bump electrodes 15 of the first semiconductor chip 27-1 and the second bump electrodes 25 of the first semiconductor chip 27-2 are temporarily bonded by thermocompression bonding and that a space between the first semiconductor chip 27-1 and the second semiconductor chip 27-2 is sealed by means of the insulating resin layer 29 provided to the first semiconductor chip 27-2.

Thereby, the first semiconductor chips 27-1 and 27-2 are stacked over the second semiconductor chip 58.

As explained hereafter, "the first semiconductor chip 27" with the insulating resin layer 29 illustrated in Fig. 13 will be referred to as "a first semiconductor chip 27-3" for convenience of the description.

Subsequently, the process illustrated in Fig. 16 further sucks the first semiconductor chip 27-3 by means of the bonding tool 71 and thereafter carries out processing similar to the process illustrated in Fig. 15 so that the first bump electrodes 15 of the first semiconductor chip 27-2 and the second bump electrodes 25 of the first semiconductor chip 27-3 are temporarily bonded by thermocompression bonding and that a space between the first semiconductor chip 27-2 and the second semiconductor chip 27-3 is sealed by means of the insulating resin layer 29 provided to the first semiconductor chip 27-3.

Thereby, the first semiconductor chips 27-1, 27-2, and 27-3 are stacked over the second semiconductor chip 58.

Referring now to Fig. 16, the description will proceed to structure of a first semiconductor chip 78 stacked over the first semiconductor chip 27-3 and a manufacturing method thereof.

The first semiconductor chip 78 comprises an interface semiconductor chip. The first semiconductor chip 78 is similar in structure to the first semiconductor chip 27-1 except that a first circuit element layer 81, first bump electrodes 82, and second bump electrodes 84 are provided instead to the first circuit element layer 12, the first bump electrodes 15, and the second bump electrodes 25 provided in the first semiconductor chip 27-1, respectively.

The first circuit element layer 81 is formed on the first surface 11a of the semiconductor substrate 11. In the first circuit element layer 81, interface circuit elements (not shown) are formed.

The first bump electrodes 82 are provided to a surface 81a of the first circuit element layer 81 that is exposed from the opening portions 14A formed in the protection film 14.

The second bump electrodes 84 are provided on the second surface 11 b of the semiconductor substrate 11 through an insulating layer which is not illustrated. The second bump electrodes 84 are connected to the first bump electrodes 82 via the through electrodes 24 or a wiring pattern which is not illustrated.

In addition, the first and the second bump electrodes 82 and 84 are electrically connected to the interface circuit elements (not shown) formed in the first circuit element layer 81.

The first semiconductor chip 78 having the above-mentioned structure is formed by processing similar to the processes illustrated in Figs. 1 through 13 which are described above. Therefore, in the manner similar to the first semiconductor chip 27 shown in Fig. 13, a surface (a back surface) of the first semiconductor chip 78 on which the second bump electrodes 84 are formed is covered with the insulating resin layer 29. In addition, the insulating resin layer 29 provided to the first semiconductor chip 78 is formed so as to cover the second bump electrodes 84.

Subsequently, the process illustrated in Fig. 16 furthermore sucks the first semiconductor chip 78 by means of the bonding tool 71 and thereafter carries out processing similar to the process illustrated in Fig. 15 so that the first bump electrodes 15 of the first semiconductor chip 27-3 and the second bump electrodes 84 of the first semiconductor chip 78 are temporarily bonded by thermocompression bonding and that a space between the first semiconductor chip 27-3 and the second semiconductor chip 78 is sealed by means of the insulating resin layer 29 provided to the first semiconductor chip 78.

Subsequently, the process illustrated in Fig. 16 applies a load by pressing the first semiconductor chip 78 by means of the bonding tool 71 in a state of heating the first semiconductor chips 27-1, 27-2, 27-3, and 78 and the second semiconductor chip 58 which are stacked at the order of 300°C, real bonding is made among the first semiconductor chips 27-1, 27-1, 27-3, and 78 and the second semiconductor chip 58 which are temporary bonded.

Therefore, a chip stacked structure 86, in which the second semiconductor chip 58, the first semiconductor chip 27-1, the first semiconductor chip 27-2, the first semiconductor chip 27-3, and the first semiconductor chip 78 are stacked in order, are formed.

Incidentally, in Fig. 16, the first semiconductor chip 78 is an uppermost layer chip which disposed in an uppermost layer.

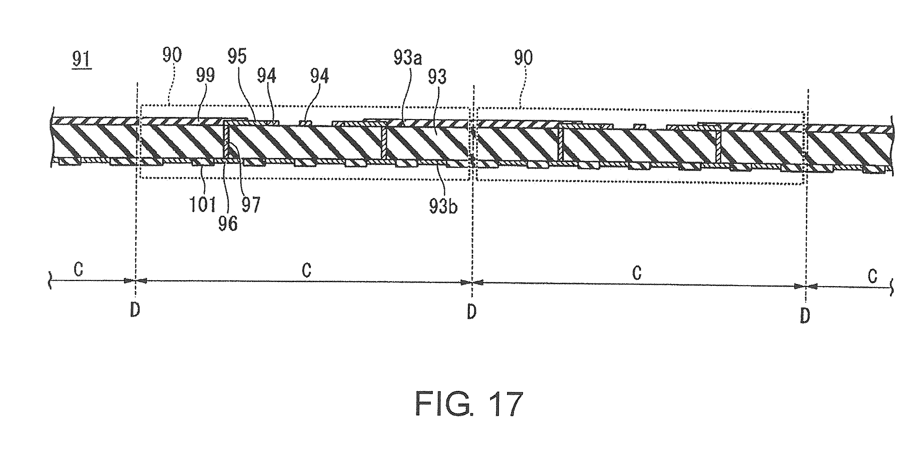

Subsequently, a process illustrated in Fig. 17 prepares a wiring motherboard 91 where a plurality of wiring substrates 90 are coupled to each other. Referring now to Fig. 17, the description will proceed to structure of the wiring motherboard 91.

The wiring motherboard 91 has structure where the plurality of wiring substrates 90 are coupled to each other and comprises a substrate body 93, connection pads 94, a wiring pattern 95, external connection pods 96, through electrodes 97, a first solder resist 99, and a second solder resist 101.

The substrate body 93 is partitioned by dicing lines D and has a plurality of wiring substrate forming areas C in which the wiring substrates 90 are formed. As the substrate body 93, for example, a glass epoxy board may be used.

The connection pads 94 are disposed in central portions of the wiring substrate forming areas C in a main surface 93a of the substrate body 93. The connection pads 94 comprise electrodes connected to the first bump electrodes 82 provided to the first semiconductor chip 78 constituting the chip stacked structure 86 shown in Fig. 16.

The wiring pattern 95 is configured so as to become integrated to the connection pads 94 and is provided in the main surface 93a of the substrate body 93 corresponding to the wiring substrate forming areas C. The wiring pattern 95 comprises a pattern far rewiring.

The external connection pads 96 are provided on a back surface 93b of the substrate body 93 corresponding to the wiring substrate forming areas C.

The though electrodes 97 are provided so as to penetrate the substrate body 93 corresponding to the wiring board forming areas C. The through electrodes 97 have upper ends connected to the wiring pattern 95 and lower ends connected to the external connection pads 96. Thereby, the through electrodes 97 electrically connect the external connection pads 96 with the connection pads 94.

The first solder resist 99 is provided on the main surface 93a of the substrate body 93 corresponding to the wiring substrate forming areas C and the dicing lines D so as to expose the connection pads 94. The first solder resist 99 is provided so as to cover parts of the wiring pattern 95. The first solder resist 99 has a function for protecting the wiring pattern 95.

The second solder resist 101 is provided on the back surface 93b of the substrate body 93 corresponding to the wiring substrate forming areas C and the dicing lines D so as to expose the external connection pads 96.

The wiring substrate 90 is configured to comprise the connection pads 94, the wiring pattern 95, the external connection pads 96, the through electrodes 97, the substrate body 93 corresponding to the wiring substrate forming area C, the first solder resist 99, and the second solder resist 101.

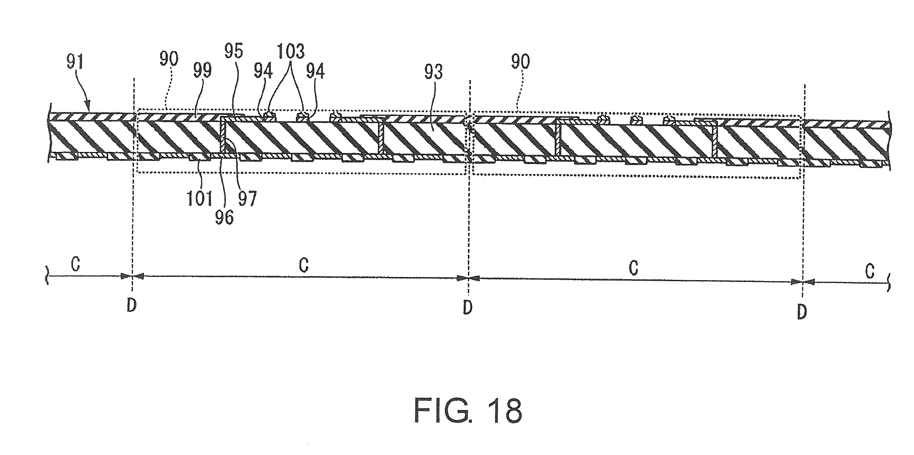

Subsequently, a process illustrated in Fig. 18 forms wire bumps 103 on the connection pads 94. Specifically, each wire bump 103 is formed by compression bonding an object in which a molten ball is formed in a tip of a wire consisting of, for example, Au, Cu, or the like on an upper surface of the connection pad 94 by ultrasound by means of a wire bonding device (not shown), and thereafter by pulling and cutting a rear end of the wire.

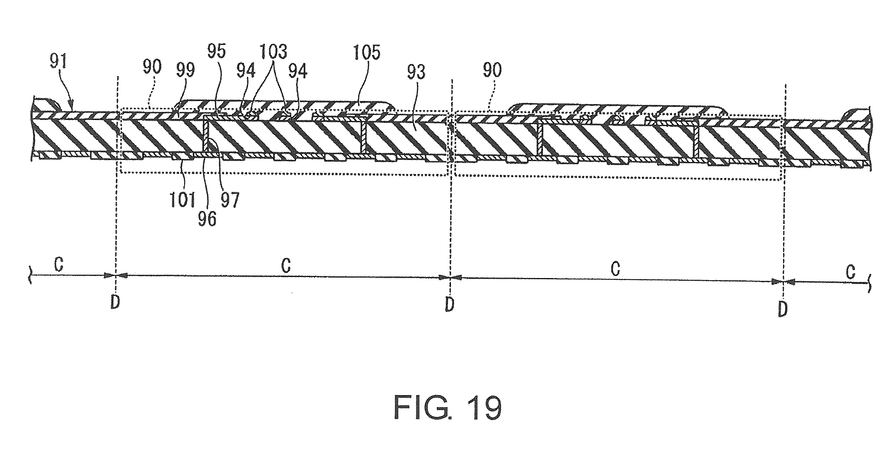

Subsequently, a process illustrated in Fig. 19 disposes a liquid undefill resin 105 on a central portion of each wiring substrate forming area C so as to cover the wire bumps 103.

Specifically, the liquid underfill resin 105 is formed by supplying a liquid NCP (Non conductive Paste) from a dispenser (not shown). The liquid underfill resin 105 is also called an insulating resin paste. In this connection, the NCP is also made of an epoxy-based resin as with the NCF and contains a flux activator in order to favorably connect between bump electrodes on connecting of the flip chip of the chip stacked structure. The flux activator may be, for example, organic acid or amine.

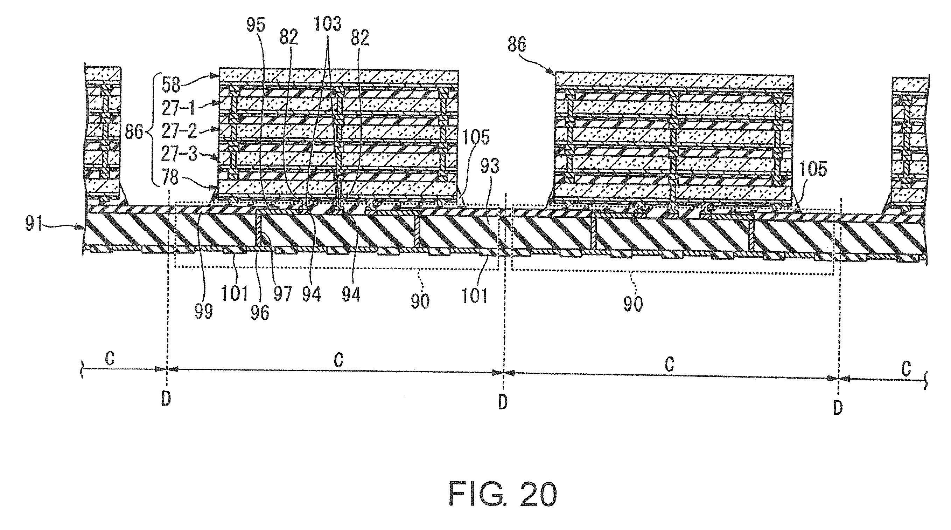

Subsequently, a process illustrated in Fig. 20 picks up the chip stacked structure 86 taken out of the bonding device 55 shown in Fig. 16 by means of a bonding tool (not shown), and oppositely disposes the first bump electrodes 82 of the first semiconductor chip 78 constituting the chip stacked structure 86 and the connection pads 94 of the wiring substrate 90.

Subsequently, the process illustrated in Fig. 20 further pushes the chip stacked structure 86 to the wiring substrate 90 (the wiring motherboard 91) heated by means of the bonding tool (not shown) in a state where the chip stacked structure 86 is heated at high temperature (e.g. the order of 300°C) to thermocompression boding the first bump electrodes 82 with the connection pads 94 via the wire bumps 103 and to seal a space formed between the chip stacked structure 86 and the wiring substrate 90 by means of the underfill resin 105.

Thereby, the chip stacked structure 86 is connected to the wiring substrate 90 in a flip chip fashion, and therefore the chip stacked structure 86 and the wiring substrate 90 are electrically connected to each other.

In this connection, in the process illustrated in Fig. 20, the chip stacked structures 86 are housed to all of the wiring substrates 90 constituting the wiring motherboard 91. In this connection, the first semiconductor chip 78 is called a lowermost semiconductor chip because the first semiconductor chip 78 is disposed in the lowermost part of the chip stacked structure 86.

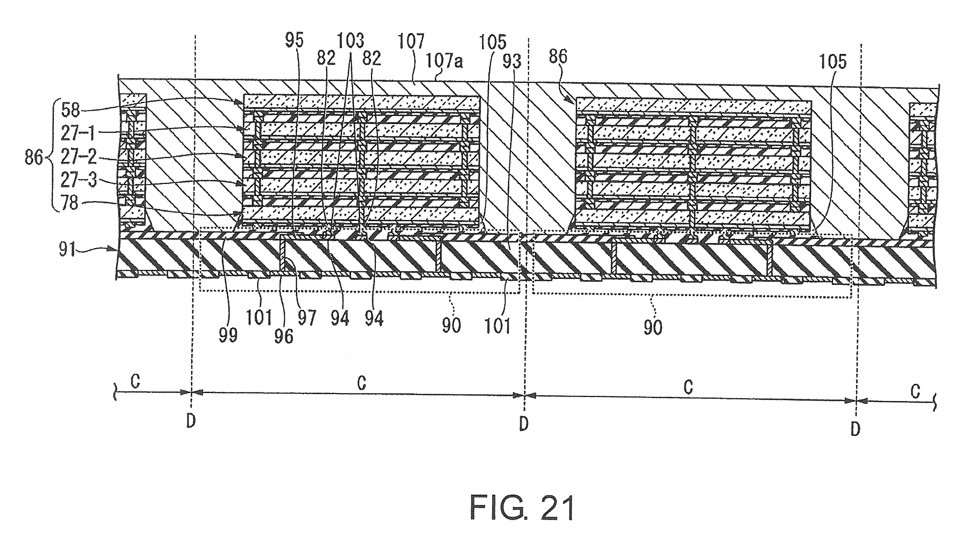

Subsequently, a process illustrated in Fig. 21 forms a molded resin 107 which seals the plurality of chip stacked structures 86 housed in the wiring motherboard 91 in collection manner and which has an upper surface 107a serving as a flat surface. The molded resin 107 is formed, for example, by means of a transfer molding method.

More specifically, the structure shown in Fig. 20 is accommodated in a space formed between an upper die and a lower die, and thereafter a heat molten molded resin 107 is injected into the space in question. Subsequently, the molten molded resin 107 is heated (cured) at predetermined temperature (e.g. the order of 180°C), and then is baked at predetermined temperature to completely cure the molded resin 107.

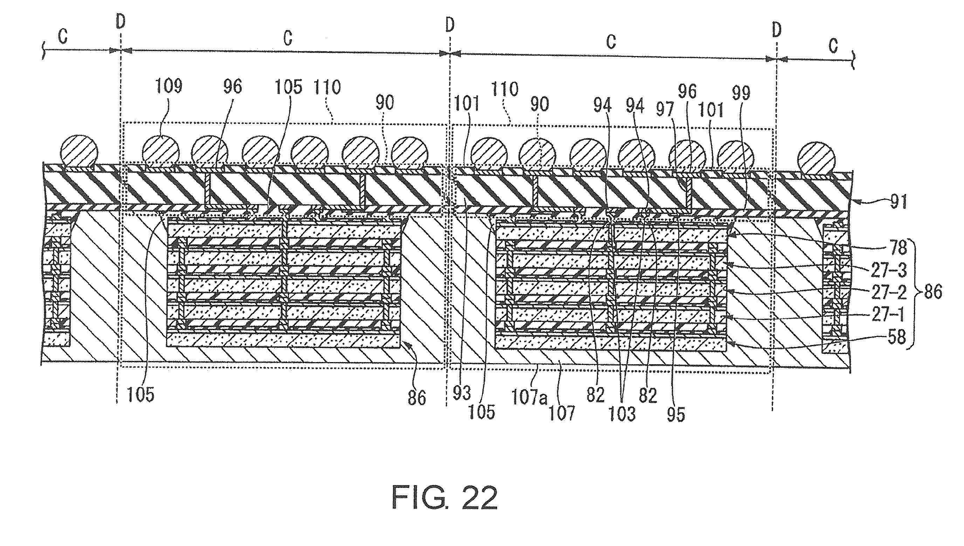

Thereby, the molded resin 107 for sealing the plurality of chip stacked structures 86 in the collective manner is formed. As the molded resin 107, for example, a thermosetting resin such as an epoxy-based resin or the like may be used. Subsequently, a process illustrated in Fig. 22 turns the structure shown in Fig. 21 upside down, and thereafter forms external connection terminals 109 on the plurality of external connection pads 96 formed in the wiring substrates 90.

Thereby, a plurality of semiconductor devices 110, each of which comprises the wiring substrate 90, the chip stacked structure 86, the underfill resin 105, the molded resin 107, and the external connection terminals 109 and which are coupled to each other, are formed. As each external connection terminal 109, for example, a solder ball may be used.

Under the circumstances, flux is transferred to the plurality of solder balls with the plurality of solder balls sucked and held by means of a mounting tool of a ball mounter comprising a plurality of sucking holes (not shown). Subsequently, the solder balls are mounted on the plurality of external connection pads 96 formed in the wiring substrate 90, and thereafter the wiring motherboard 91 in which the solder balls are formed is subjected to heat treatment (reflow treatment). Thereby, the solder balls are fixed to the external connection pads 96 provided to the plurality of wiring substrates 90.

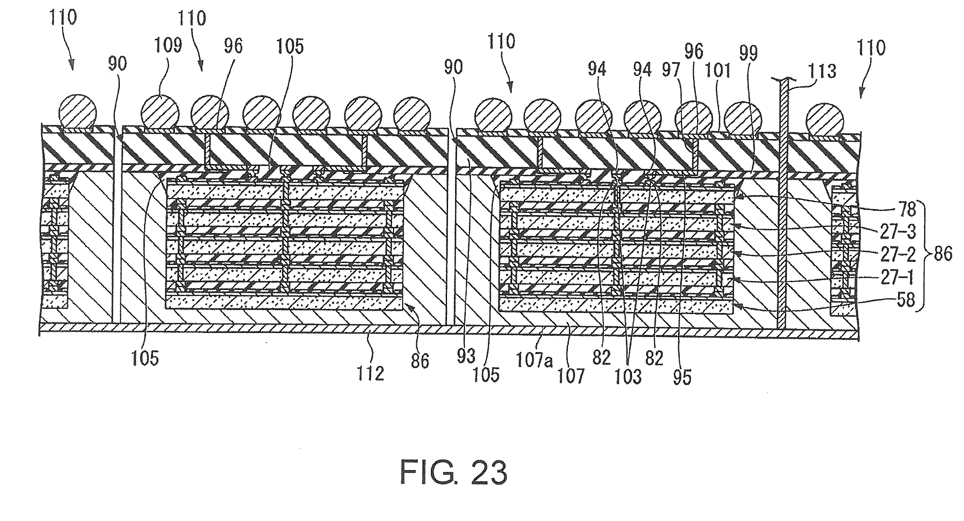

Subsequently, a process illustrated in Fig. 23 pastes a dicing tape 112 on the upper surface 107a of the molded resin 107. Subsequently, the process illustrated in Fig. 23 further cuts the wiring motherboard 91 and the molded resin 107 shown in Fig. 22 along the dicing lines D by means of a dicing blade 113 to individualize the plurality of semiconductor devices 110. In this event, the wiring substrates 90 are also individualized.

Subsequently, a process illustrated in Fig. 24 turns the structure shown in Fig. 23 upside down, and thereafter peels off the dicing tape 112 to manufacture the plurality of semiconductor devices 110 of CoC (Chip on Chip) type.

Specifically, the semiconductor device (110) according to a second exemplary embodiment comprises:
the wiring substrate (90);
the chip stacked structure (86) including the plurality of semiconductor chips (58, 27-1, 27-2, 27-3, 78) stacked with each other and the insulating resin film (29) provided in a space between adjacent ones of the semiconductor chips without covering a side surface of the adjacent ones of the semiconductor chips, the chip stacked structure (86) being mounted over the wiring substrate (90), and the insulating resin film (29) including a flux activator; and
the insulating resin paste (105) provided in a space between the wiring substrate (90) and the chip stacked structure (86), the insulating resin paste (105) being covered a side surface of the lowermost semiconductor chip (78) of the chip stacked structure (86), the lowermost semiconductor chip (78) being closest to the wiring substrate (90).

In the semiconductor device 110, the first semiconductor chips 27-1, 27-2, and 27-3 may be removed from the semiconductor device 110.

Under the circumstances, a semiconductor device according to a third exemplary embodiment comprises:
the first semiconductor chip (78) including the first surface (11a), the second surface (11b) opposite to the first surface, the first electrode (82) formed on the first surface, and the second electrode (84) formed on the second surface;
the second semiconductor chip (58) including the third surface (11a), the fourth surface (11 b) opposite to the third surface, and the third electrode (66) formed on the third surface, the fourth surface being free of any electrode, the second semiconductor chip (58) being stacked over the first semiconductor chip (78) so that the third electrode (58) electrically connects to the second electrode (84);
the insulating resin film (29) including the flux activator, the insulating resin film (29) being provided in a space between the first and second semiconductor chips, a side surface of the insulating resin film (29) being substantially equal to that of each of the first and second semiconductor chips;
the wiring substrate (90) including the upper surface (93a), the lower surface (93b) and the connection pad (94) on the upper surface, the wiring substrate (90) being stacked over the first semiconductor chip (78) so that the connection pad (94) electrically connects to the first electrode (82); and
the insulating resin paste (105) provided in a space between the first semiconductor chip (78) and the wiring substrate (90), the insulating resin paste (105) being covered a side surface of the first semiconductor chip (78).

According to the method of manufacturing the semiconductor device 110 of this exemplary embodiment, it is possible to inhibit the first semiconductor chip 27 from being damaged (concretely, a damage such as a chip clack making the though electrodes 97 the starting points, and so on) and to inhibit the first semiconductor chip 27 from missing of picking-up. This is because the second bump electrodes 25 are not embedded in the adhesive layer 34 constituting the dicing tape 32 by pasting the dicing tape 32 via the insulating resin layer 29 on the surface of the semiconductor chip forming motherboard 20 that is positioned at the side where the second bump electrodes 25 are provided.

In addition, by picking-up the first semiconductor chip 27 individualized together with the insulating resin layer 29 from the dicing tape 32, it is possible to inhibit the first semiconductor chip 27 from occurring warp on picking-up although the first semiconductor chip 27 comprises the semiconductor chip subjected to the thin plate because the insulating resin layer 29 serves as the supporting plate for the first semiconductor chip 27.

Incidentally, it is possible for the first semiconductor chip 78 to obtain an effect similar to the first semiconductor chip 27 in a case of picking-up, from the dicing tape, the first semiconductor chip 78 which is formed by a technique similar to the first semiconductor chip 27 and where the surface in which the second bump electrodes 84 are formed is covered with the insulating resin layer 29.

In addition, by pushing the first semiconductor chip 27-1 with the insulating resin layer 29 to the second semiconductor chip 58 through the insulating resin layer 29 to thermocompression bonding the second bump electrodes 25 with the third bump electrodes 66, it is possible to inhibit the first semiconductor chip 27-1 from being damaged on pushing and it is possible to connect the second bump electrodes 25 with the third bump electrodes 66 with a high degree of positional precision because the insulating resin layer 29 acts as the supporting plate for inhibiting the warp of the first semiconductor chip 27-1 subjected to the thin plate.

In this connection, the above-mentioned effect can be obtained on making the second bump electrodes 84 of the first semiconductor chip 78 covered with the insulating resin layer 29 thermocompression bonding to the first bump electrodes 15 of the first semiconductor chip 27-3.

Furthermore, by pushing the first semiconductor chip 27-1 with the insulating resin layer 29 to the second semiconductor chip 58 through the insulating resin layer 29 to thermocompression bonding the second bump electrodes 25 with the third bump electrodes 66, it is possible to simplify the manufacturing method for the semiconductor device 110 (see, Fig. 24). This is because the molten insulating resin layer 29 serves as the underfill resin for sealing the space between the first semiconductor chip 27-1 and the second semiconductor chip 58 and it is therefore unnecessary to separately provide the process forming the underfill resin for sealing the space between the first semiconductor chip 27-1 and the second semiconductor chip 58.

In this connection, the above-mentioned effect can be obtained on making the second bump electrodes 84 of the first semiconductor chip 78 covered with the insulating resin layer 29 thermocompression bonding to the first bump electrodes 15 of the first semiconductor chip 27-3.

Although the inventions have been described above in connection with several preferred embodiments thereof, it will be appreciated by those skilled in the art that those embodiments are provided solely for illustrating the invention, and should not be relied upon to construe the appended claims in a limiting sense.

For example, although the description has been made citing an example of a case where the insulating resin layer 29 is provided so as to cover the side of the back surfaces of the first semiconductor chips 27-1, 27-2, 27-3, and 78 (the side in which the second bump electrodes 25 and 84 are formed) and the respective first semiconductor chips are mounted on other semiconductor chips via the insulating resin layer 29, the first semiconductor chips 27-1, 27-2, 27-3, and 78 each having the back surface in which the insulating resin layer 29 is formed may be mounted on the wiring substrate 90 via the insulating resin layer 29.

The whole or part of the exemplary embodiments disclosed above can be described as, but not limited to, the following supplementary notes,

(Supplementary note 1) A method of manufacturing a semiconductor device, comprising:
preparing a semiconductor chip forming motherboard, the semiconductor chip forming motherboard comprising a first semiconductor substrate including a plurality of chip forming areas in which a plurality of first semiconductor chips are formed and dicing areas for partitioning the plurality of chip forming areas, a first circuit element layer formed in the plurality of chip forming areas within a first surface of the first semiconductor substrate, first bump electrodes formed on a main surface of the first circuit element layer, and second bump electrodes formed on a second surface of the first semiconductor substrate that is positioned at an opposed location to the first surface, the second bump electrodes being electrically connected to the first bump electrodes, the plurality of first semiconductor chips being coupled to one another;
pasting a dicing tape with an adhesive layer via an insulating resin layer covering the second bump electrodes on the second surface of the semiconductor chip forming motherboard;
individualizing the plurality of first semiconductor chips by cutting the semiconductor chip forming motherboard and the insulating resin layer pasted to the dicing tape along the dicing areas from a side in which the first bump electrodes are formed; and
picking up the plurality of first semiconductor chips individualized together with the insulating resin layer from the dicing tape one after another.

(Supplementary note 2) A method according to Supplementary note 1, wherein the preparing the semiconductor chip forming motherboard comprising:
exposing the first bump electrodes on the surface of the first circuit element layer; and
forming a protection film consisting of an insulating resin.

(Supplementary note 3) A method according to Supplementary note 1 or 2, wherein the preparing the semiconductor chip forming motherboard comprising:
bonding a supporting substrate via an adhesive member to a surface of the semiconductor chip forming motherboard in which the protection film is formed;
making the first semiconductor substrate a thin plate before forming the second bump electrodes;
forming through electrodes penetrating parts of the first element layer and the semiconductor substrate that are opposite to the first bump electrodes, the through electrodes being electrically isolated to the semiconductor substrate and having one ends connected to the first bump electrodes;
forming the second bump electrodes to another ends of the through electrodes.

(Supplementary note 4) A method according to Supplementary note 3, wherein further comprising removing the adhesive member and the supporting substrate between the pasting the dicing tape and the individualizing the first semiconductor chips.

(Supplementary note 5) A method according to any one of Supplementary notes 1-4, wherein further comprising:
preparing a second semiconductor chip comprising a second circuit element layer formed on a third surface of a second semiconductor substrate and third bump electrodes formed on a surface of the second circuit element; and
forming a chip stacked structure comprising the first and the second semiconductor chips which are stacked by oppositely disposing the first semiconductor chip on the second semiconductor chip via the insulating resin layer and pressing the second semiconductor chip to thermocompression bond the second bump electrodes with the third bump electrodes.

(Supplementary note 6) A method according to Supplementary note 5, wherein the forming the chip staked structure forms a chip stacked structure by stacking and mounting the plurality of first semiconductor chips on the second semiconductor chip.

(Supplementary note 7) A method according to Supplementary note 6, wherein the second semiconductor chip comprises a memory semiconductor chip,
wherein, among the plurality of first semiconductor chips mounted on the second semiconductor chip, an uppermost layer chip disposed to an uppermost layer thereof comprises an interface semiconductor chip while chips other than the uppermost layer chip comprise memory semiconductor chips.

(Supplementary note 8) A method according to Supplementary note 7, wherein further comprising:
preparing a wiring substrate comprising a wiring substrate body, connection pads disposed on an upper surface of the wiring substrate body, and external connection pads which are disposed on a lower surface of the wiring substrate body and which are electrically connected to the connection pads; and
mounting the chip stacked structure on the wiring substrate by connecting the connection pads with the first bump electrodes of the uppermost layer chip constituting the chip stacked structure via an underfill resin.

(Supplementary note 9) A method according to Supplementary note 8, wherein further comprising:
forming a sealing resin for sealing the chip stacked structure on a surface of the wiring substrate; and
disposing external connection terminals to the external connection pads after forming the sealing resin.

### Industrial Applicability:

This invention can be applied to a method of manufacturing a semiconductor device.

## Claims

1. A semiconductor device comprising:
a first semiconductor chip (27; 27-1; 27-2; 27-3; 78) including a first surface (11a), a second surface (11b) opposite to the first surface, a first electrode (15; 82) formed on the first surface, a second electrode (25; 82) formed on the second surface, and a through electrode (24) electrically connecting the first electrode to the second electrode;
a second semiconductor chip (58) including a third surface (11 a), a fourth surface (11b) opposite to the third surface, and a third electrode (66) formed on the third surface, the fourth surface being free of any electrode, the second semiconductor chip (58) being stacked over the first semiconductor chip (27; 27-1) so that the third electrode (66) electrically connects to the second electrode (25);
an insulating resin film (29) including a flux activator, the insulating resin film being provided in a space between the first and second semiconductor chips (27; 27-1, 58).

2. The semiconductor device as claimed in claim 1, wherein the first semiconductor chip (27; 27-1; 27-2; 27-3; 78) comprises:
a first semiconductor substrate (11) having the first and the second surfaces; and
a first circuit element layer (12; 81) formed on the first surface (11 a), the first circuit element layer (12; 81) including a transistor element connected to the first electrode (15;82).

3. The semiconductor device as claimed in claim 1 or 2, wherein the second semiconductor chip (58) comprises:
a second semiconductor substrate (11) having the third and the fourth surfaces (11a, 11b); and
a second circuit element layer (65) formed on the third surface (11a), the second circuit element layer (65) including a transistor element connected to the third electrode (66).

4. The semiconductor device as claimed in any one of claims 1-3, wherein a side surface of the insulating resin film (29) is substantially equal to that of each of the first and second semiconductor chips (27; 27-1; 27-2; 27-3; 78, 58).

5. The semiconductor device as claimed in any one of claims 1-4, further comprising:
a wiring substrate (90) including an upper surface (93a), a lower surface (93b) opposite to the upper surface and a connection pad (94) formed on the upper surface, the wiring substrate (90) being stacked over the first surface (11a) of the first semiconductor chip (78) so that the connection pad (94) electrically connects to the first electrode (82) of the first semiconductor chip (78).

6. The semiconductor device as claimed in claim 5, further comprising:
an insulating resin paste (105) provided in a space between the first semiconductor chip (78) and the wiring substrate (90), the insulating resin paste (105) being covered a side surface of the first semiconductor chip (78).

7. The semiconductor device as claimed in claim 6, wherein the insulating resin paste (105) includes a flux activator.

8. The semiconductor device as claimed in claim 5, further comprising:
a sealing resin (107) provided over the upper surface (93a) of the wiring substrate (90) to cover the first semiconductor chip (27; 27-1; 27-2; 27-3; 78), the second semiconductor chip (58) and the insulating resin film (29).

9. The semiconductor device as claimed in claim 1, wherein each of the first and second semiconductor chips (27; 27-1; 27-2; 27-3; 58) comprises a memory semiconductor chip.

10. The semiconductor device as claimed in claim 9, wherein the memory semiconductor chip comprises a DRAM chip.

11. The semiconductor device as claimed in claim 1, wherein the first semiconductor chip (78) comprises an interface semiconductor chip, and the second semiconductor chip (58) comprises a memory semiconductor chip.

12. The semiconductor device as claimed in claim 11, wherein the memory semiconductor chip comprises a DRAM chip.

13. The semiconductor device as claimed in claim 5, further comprising:
a wire bump (103) provided between the connection pad (94) of the wiring substrate (90) and the first electrode (82) of the first semiconductor chip (78), the connection pad (94) being electrically connected to the first electrode (82) of the first semiconductor chip (78) via the wire bump (103).
